# EUROPEAN PATENT SPECIFICATION

(11) **EP 1 640 472 B1**
(45) Date of publication and mention of the grant of the patent: **18.07.2007**
(21) Application number: 05104632.4
(22) Date of filing: 30.05.2005
(51) Int. Cl.: C23C 14/08, C23C 14/02, C23C 14/34

(54) **Method for reactive sputter deposition of a magnesium oxide film on an iron-containing film**
Reaktive Zerstaubungsablagerungsverfahren eines Magnesiumoxidsfilms auf einem Eisen-enthaltenden Film
Méthode de déposition d'un film d'oxyde de magnésium sur un film contenant du fer par pulvérisation cathodique réactive

(30) Priority: 26.08.2004 US 927928
(43) Date of publication of application: 29.03.2006
(73) Proprietor: Hitachi Global Storage Technologies B. V., 01 AZ Amsterdam (NL)
(72) Inventor: Mauri, Daniele, San Jose, CA 95193 (US)
(74) Representative: Kirschner, Klaus Dieter

(56) References cited:
- EP-A- 1 391 942
- WO-A-98/42890
- US-A- 6 150 030
- HEHN M ET AL: "Low-height sputter-deposited magnesium oxide tunnel barriers: experimental report and free electron modeling" EUROPEAN PHYSICAL JOURNAL B EDP SCIENCES; SPRINGER-VERLAG FRANCE, vol. 40, no. 1, July 2004 (2004-07), pages 19-23, XP002365185 ISSN: 1434-6028

## Description

This invention relates generally to a method for reactive sputter deposition of a magnesium oxide (MgO) film on an iron-containing film and in particular to a method for fabricating magnetic tunnel junction (MTJ) devices, and more particularly to a method for forming a magnesium oxide (MgO) tunnel barrier in a MTJ.

A magnetic tunnel junction (MTJ) is comprised of two layers of ferromagnetic material separated by a thin insulating tunnel barrier. The tunnel barrier is sufficiently thin that quantum-mechanical tunneling of the charge carriers occurs between the ferromagnetic layers. The tunneling process is electron-spin-dependent, which means that the tunneling current across the junction depends on the spin-dependent electronic properties of the ferromagnetic materials and is a function of the relative orientation of the magnetic moments (magnetization directions) of the two ferromagnetic layers. The two ferromagnetic layers are designed to have different responses to magnetic fields so that the relative orientation of their moments can be varied with an external magnetic field.

Various devices using a MTJ have been proposed. One MTJ device is a magnetic memory cell in a nonvolatile magnetic random access memory (MRAM), as described in U.S. Patent 5,640,343. Another MTJ device is a magnetic tunnel transistor (MTT), as described by S. van Dijken, X. Jiang, and S. S. P. Parkin, "Room Temperature Operation of a High Output Magnetic Tunnel Transistor", Appl. Phys. Lett. 80, 3364 (2002). A MTJ magnetic field sensor has also been proposed, particularly as a magnetoresistive read head in a magnetic recording disk drive as described in U.S. Patent 5,729,410.

An important property for a MTJ device is the signal-to-noise ratio (SNR). The magnitude of the signal is dependent upon the tunneling magnetoresistance or TMR (deltaR/R) exhibited by the device. The signal is given by i_{B} (deltaR), which is the bias current (i_{B}) passing through the MTJ device (assuming a constant current is used to detect the signal) times the resistance change (deltaR) of the device. However, the noise exhibited by the MTJ device is determined, in large part, by the resistance (R) of the device. Thus to obtain the maximum SNR for constant power used to sense the device the resistance (R) of the device must be small and the change in resistance (deltaR) of the device large.

The resistance of a MTJ device is largely determined by the resistance of the insulating tunnel barrier for a device of given dimensions since the resistance of the electrical leads and the ferromagnetic layers contribute little to the resistance. Moreover, because the sense current passes perpendicularly through the ferromagnetic layers and the tunnel barrier, the resistance (R) of a MTJ device increases inversely with the area (A) of the device. The requirement for low resistance MTJ devices, coupled with the inverse relationship of resistance with area, is especially troublesome because an additional requirement for MTJ device applications is small area. For example, for an MRAM the density of MTJ memory cells depends on small area MTJs, and for a read head a high storage density requires a small data trackwidth on the disk, which requires a small area MTJ read head. Since the resistance (R) of a MTJ device scales inversely with the area (A), it is thus convenient to characterize the resistance of the MTJ device by the product of the resistance (R) times the area (A) or the resistance-area product (RA). Thus RA is independent of the area (A) of the MTJ device.

MTJ memory cells in MRAM will need to be shrunk in size, requiring lower RA values so that the resistance of the individual cell is not too high. MTJ read heads will also need to have sub-micron size for high density magnetic recording applications, and to have low resistance values comparable to those of present giant magnetoresistive (GMR) read heads. Thus MTJs with low RA and high TMR are desirable.

In prior art MTJs, the material used for the tunnel barrier is amorphous aluminum oxide (Al₂O₃) because such barrier layers can be made very thin and essentially free of pin holes. The Al₂O₃ tunnel barrier is made by deposition of an aluminum layer followed by natural or plasma oxidation. For Al₂O₃ tunnel barriers it has been found that RA increases exponentially with the thickness of the barrier. However, for relatively low RA values of around 20 Ω-(µm)², the TMR is typically reduced, most likely because of the formation of quantum point defects or microscopic pin holes in the ultra-thin tunnel barriers needed to obtain these relatively low RA values.

More recently, MTJs with epitaxial tunnel barriers of MgO have been investigated and show promise as a replacement for amorphous Al₂O₃ tunnel barriers. See M. Bowen et al., "Large magnetoresistance in Fe/MgO/FeCo (001) epitaxial tunnel junctions", Appl. Phys. Lett. 79, 1655 (2001); and S. Mitani et al., "Fe/MgO/Fe(100) epitaxial magnetic tunnel junctions prepared by using in situ plasma oxidation", J. Appl. Phys. 90, 8041 (2003). These MgO tunnel barriers have been prepared by laser ablation, molecular beam epitaxy, and by the method used for amorphous Al₂O₃ tunnel barriers, i.e., conventional vacuum deposition followed by *in situ* plasma oxidation.

The conventional method of forming the tunnel barrier by vacuum deposition of the metal followed by oxidation is very delicate and must be re-optimized for every deposited metal thickness. This method can also be very slow due to the post-deposition oxidation step. Too little oxidation leaves behind under-oxidized metal, while too much oxidation attacks the underlying film. In both the under-oxidized and over-oxidized cases the MTJ performance can be severely degraded.

Thus, it is desirable to develop a process for forming a MTJ tunnel barrier that results in MTJ devices with low RA and high TMR, and that does not suffer from the problems associated with the prior art processes.

The invention is a method for reactive sputter deposition of a magnesium oxide (MgO) tunnel barrier onto an iron-containing film. The method is part of the fabrication of a MTJ and the iron-containing film is the lower ferromagnetic film in the MTJ. The MgO tunnel barrier is sputter deposited from a Mg target in the presence of reactive oxygen (O₂) gas in the "high-voltage" state to assure that deposition occurs with the Mg target in its metallic mode, i.e., no or minimal oxidation.

The walls of the sputter deposition chamber are first conditioned by applying power to activate a Mg target in the presence of the argon (Ar) inert sputtering gas while the iron-containing film is protected by a movable shutter. This conditioning step coats the chamber walls with the Mg metal, and thus removes any "memory" of prior oxygen processes in the chamber, which is important for a repeatable reactive deposition process. With the shutter still protecting the iron-containing film, the reactive O₂ gas is introduced into the chamber at a predetermined flow rate. After the O₂ flow has stabilized, the shutter is opened and the Mg target is activated for a specific time to achieve the desired tunnel barrier thickness. The specific time has been previously determined, from the known O₂ flow rate, to assure that the sputter deposition occurs while there is minimal oxidation of the Mg target.

Because the metallic mode of the Mg target has a finite lifetime, a set of O₂ flow rates and associated sputter deposition times are established, with each flow rate and deposition time assuring that deposition occurs with the Mg target in the metallic mode and resulting in a known tunnel barrier thickness. The commencement of target oxidation is associated with a decrease in target voltage, so the sputtering can also be terminated by monitoring the target voltage and terminating application of power to the target when the voltage reaches a predetermined value. Since deposition should occur only while the Mg target is in its metallic mode, the tunnel barrier must be completed while the target is still metallic. This if a thicker tunnel barrier is required it is deposited in several layers, with the process described above repeated for each layer.

As an optional final step, after the sputtering has terminated, the deposited MgO tunnel barrier can be exposed to O₂ in the chamber as a "natural oxidation" to encourage the tunnel barrier to achieve its natural MgO stoichiometry.

For a fuller understanding of the nature and advantages of the present invention, reference should be made to the following detailed description taken together with the accompanying figures.
Fig. 1 is a schematic top view of a conventional magnetic recording hard disk drive with the cover removed.
Fig. 2 is an enlarged end view of the slider and a section of the disk taken in the direction 2-2 in Fig. 1.
Fig. 3 is a view in the direction 3-3 of Fig. 2 and shows the ends of the read/write head as viewed from the disk.
Fig. 4 is a cross-sectional view of a MTJ read head showing the stack of layers, including the tunnel barrier, located between the magnetic shield layers.
Fig. 5 is a schematic of the sputter deposition equipment used in the process of this invention.
Fig. 6 is a hysteresis curve for the reactive sputter deposition of MgO from a Mg target with O₂ as the reactive gas and Ar as the inert sputtering gas.
Fig. 7 is a family of curves of Mg target voltages as a function of time for a set of different O₂ flow rates.

### Prior Art

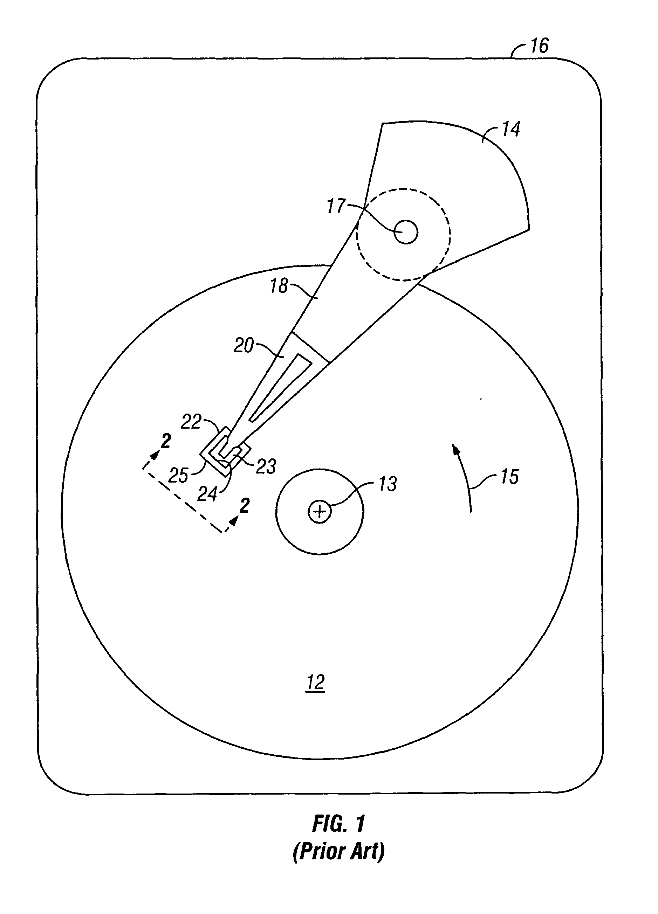

The method of this invention has application to the formation of the tunnel barrier required for a MTJ read head. The MTJ read head has application for use in a magnetic recording disk drive, the operation of which will be briefly described with reference to Figs. 1-3.

Fig. 1 is a block diagram of a conventional magnetic recording hard disk drive 10. The disk drive 10 includes a magnetic recording disk 12 and a rotary voice coil motor (VCM) actuator 14 supported on a disk drive housing or base 16. The disk 12 has a center of rotation 13 and is rotated in direction 15 by a spindle motor (not shown) mounted to base 16. The actuator 14 pivots about axis 17 and includes a rigid actuator arm 18. A generally flexible suspension 20 includes a flexure element 23 and is attached to the end of arm 18. A head carrier or air-bearing slider 22 is attached to the flexure 23. A magnetic recording read/write head 24 is formed on the trailing surface 25 of slider 22. The flexure 23 and suspension 20 enable the slider to "pitch" and "roll" on an air-bearing generated by the rotating disk 12. Typically, there are multiple disks stacked on a hub that is rotated by the spindle motor, with a separate slider and read/write head associated with each disk surface.

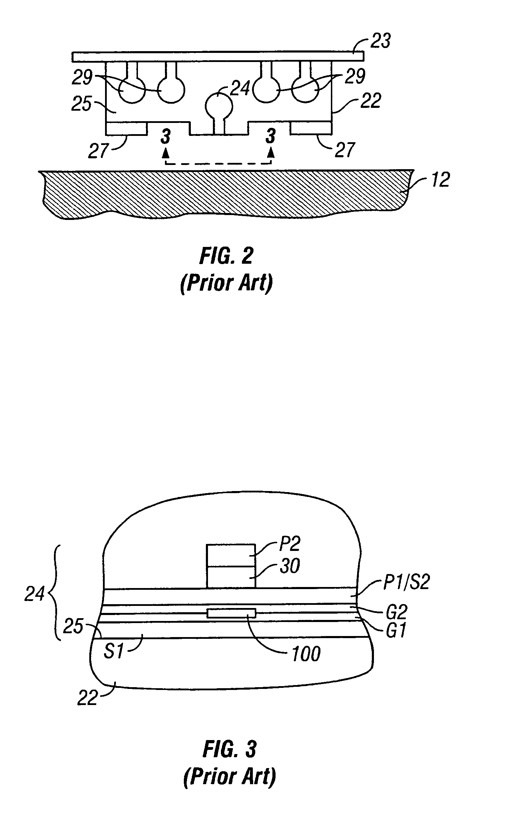

Fig. 2 is an enlarged end view of the slider 22 and a section of the disk 12 taken in the direction 2-2 in Fig. 1. The slider 22 is attached to flexure 23 and has an air-bearing surface (ABS) 27 facing the disk 12 and a trailing surface 25 generally perpendicular to the ABS. The ABS 27 causes the airflow from the rotating disk 12 to generate a bearing of air that supports the slider 20 in very close proximity to or near contact with the surface of disk 12. The read/write head 24 is formed on the trailing surface 25 and is connected to the disk drive read/write electronics by electrical connection to terminal pads 29 on the trailing surface 25.

Fig. 3 is a view in the direction 3-3 of Fig. 2 and shows the ends of read/write head 24 as viewed from the disk 12. The read/write head 24 is a series of thin films deposited and lithographically patterned on the trailing surface 25 of slider 22. The write head includes magnetic write poles P1/S2 and P1 separated by a write gap 30. The magnetoresistive sensor or read head 100 is located between two insulating gap layers G1, G2 that are typically formed of alumina. Gap layers G1, G2 are located between magnetic shields S1 and P1/S2, with P1/S2 also serving as the first write pole for the write head. If the magnetoresistive read head is the type where the sense current is perpendicular to the planes of the layers, sometimes referred to as a CPP sensor, then the read head is formed in contact with the shields S1, S2, or in contact with electrically conducting leads formed on the shields. A MTJ read head is a CPP sensor.

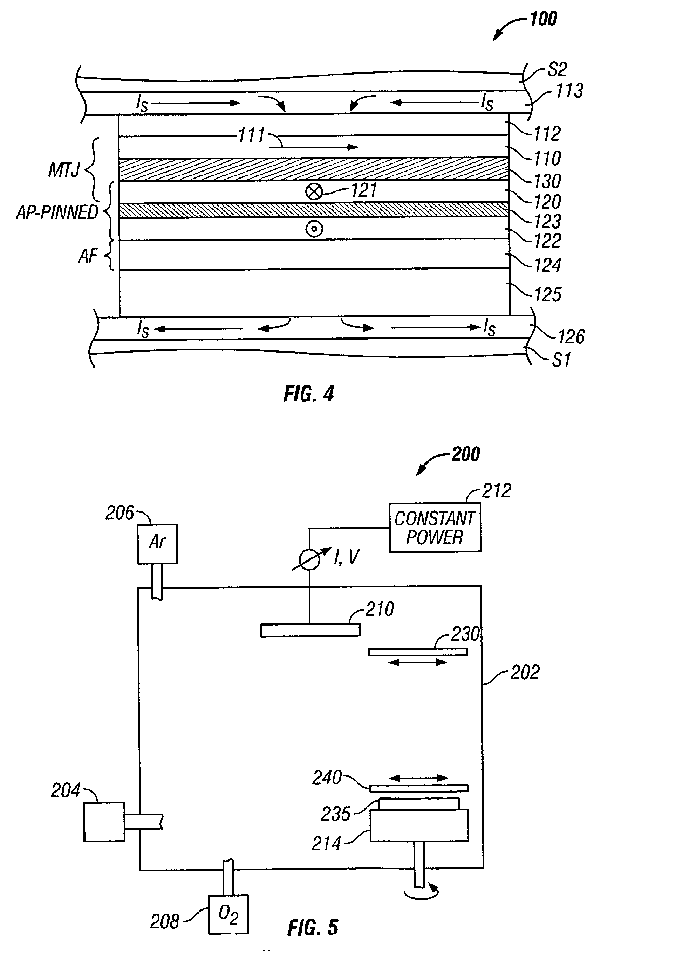

Fig. 4 is an enlarged sectional view showing the layers making up sensor 100. Sensor 100 is a MTJ read head comprising a stack of layers formed between the two magnetic shield layers S1, S2 that are typically electroplated NiFe alloy films. The lower shield S1 is typically polished by chemical-mechanical polishing (CMP) to provide a smooth substrate for the growth of the sensor stack. The sensor layers include a reference ferromagnetic layer 120 having a fixed or pinned magnetic moment or magnetization direction 121 oriented transversely (into the page), a free ferromagnetic layer 110 having a magnetic moment or magnetization direction 111 that can rotate in the plane of layer 110 in response to transverse external magnetic fields, and a nonmagnetic tunnel barrier 130 between the reference layer 120 and free layer 110. The two ferromagnetic layers 120, 110 and the tunnel barrier 130 together comprise the MTJ. The reference layer 120 is shown in Fig. 4 as part of the well-known antiparallel-pinned (AP-pinned) structure, also called a "laminated" pinned layer, as described in U.S. Patent 5,465,185. The AP-pinned structure minimizes magnetostatic coupling of the reference layer 120 with the free layer 110, and comprises the ferromagnetic reference layer 120 and a ferromagnetic pinned layer 122 separated by a non-magnetic antiferromagnetically-coupling spacer layer 123, such as Ru. The ferromagnetic pinned layer 122 is exchange-coupled to an antiferromagnetic (AF) layer 124. The reference layer 120 can also be a single layer exchange-coupled with antiferromagnetic layer 124.

Located between the lower shield layer S1 and the MTJ are the bottom electrode or electrical lead 126 and a seed layer 125. The seed layer 125 facilitates the deposition of the antiferromagnetic layer 124. Located between the MTJ and the upper shield layer S2 are a capping layer 112 and the top electrode or electrical lead 113.

In the presence of an external magnetic field in the range of interest, i.e., magnetic fields from recorded data on the disk 12, the magnetization direction 111 of free layer 110 will rotate while the magnetization direction 121 of reference layer 120 will remain fixed and not rotate. Thus when a sense current Is is applied from top lead 113 perpendicularly through the stack to bottom lead 126, the magnetic fields from the recorded data on the disk will cause rotation of the free-layer magnetization 111 relative to the pinned-layer magnetization 121, which is detectable as a change in electrical resistance.

The leads 126, 113 are typically Ta. They are optional and used to adjust the shield-to-shield spacing. The seed layer 125 is typically one or more layers of NiFeCr, NiFe, Ta or Ru. The antiferromagnetic layer 124 is typically a Mn alloy, e.g., PtMn, NiMn, FeMn, IrMn, PdMn, PtPdMn or RhMn. The capping layer 112 provides corrosion protection and is typically formed of Ru or Ta. A hard magnetic layer (not shown) may also be included in the stack for magnetic stabilization of the free ferromagnetic layer 110.

The ferromagnetic layers 123, 120, 110 are typically formed of an alloy of one or more of Co, Fe and Ni, or a bilayer of two alloys, such as a CoFe-NiFe bilayer. For example, reference ferromagnetic layer 120 may be a CoFe alloy, typically 10 to 30 Å thick, and the free ferromagnetic layer 110 may be a bilayer of a CoFe alloy, typically 10-15 Å thick and formed on the tunnel barrier 130, with a NiFe alloy, typically 10-30 Å thick, formed on the CoFe layer of the bilayer.

### The Invention

This invention is a sputter deposition process for forming a MTJ with a magnesium oxide (MgO) tunnel barrier. Fig. 5 is a schematic of the sputter deposition equipment 200, which may be an Anelva® Model C7100 or similar sputtering equipment. The equipment 200 comprises a vacuum chamber 202, a cryogenic pump 204, an inert gas supply 206, a reactive gas supply 208, a sputtering target 210, a power supply 212 connected to the target 210, and a rotatable platform 214 for the substrate. Also included are a shutter 230 to cover the target and a shutter 240 to cover the substrate 235.

The process will be described for depositing an ultra-thin (approximately 5-20Å) MgO tunnel barrier on an iron-containing metallic film, e.g., a CO₉₀Fe₁₀ ferromagnetic film. The MgO tunnel barrier is tunnel barrier 130, the CO₉₀Fe₁₀ film is reference ferromagnetic layer 120, and the substrate is the polished shield layer S1, as described above with reference to Fig. 4. The target 210 is substantially pure Mg metal, the preferred inert gas is argon (Ar) and the preferred reactive gas is oxygen gas (O₂). Prior to the process for forming the MgO tunnel barrier the other layers in the sensor 100 can be deposited in the same vacuum deposition system, using sputtering targets of the appropriate material. Thus the last step prior to the first step in the MgO tunnel barrier deposition process is the sputter deposition of the Co₉₀Fe₁₀ film 120.

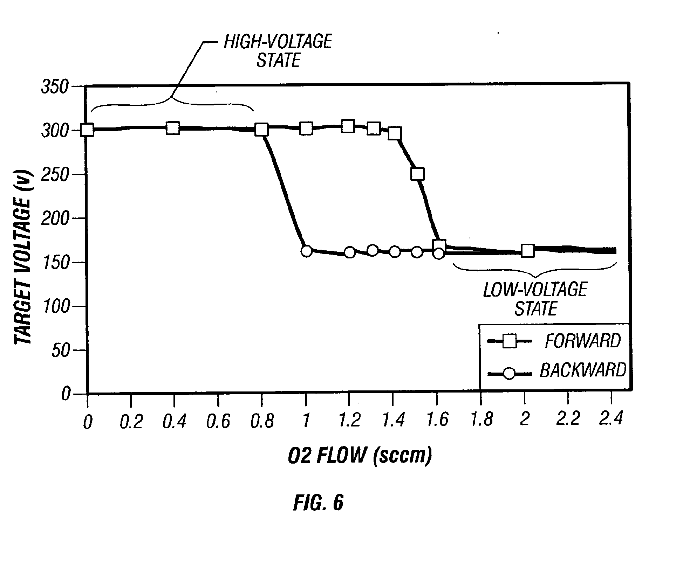

The method of this invention can be understood with reference to Fig. 6, which is a hysteresis curve for the reactive sputter deposition of MgO from a Mg target with O₂ as the reactive gas and Ar as the inert sputtering gas. In the case described with reference to Fig. 6, MgO is deposited from a metallic Mg target using pulsed DC sputtering. In the hysteresis curve the target voltage is plotted vs the O₂ gas flow rate, while the Ar gas is kept at a fixed flow rate. The curve is hysteretic, i.e., the target voltage curve is different for increasing and decreasing O₂ flow rates.

Fig. 6 shows that the target has two stable states: a high-voltage state (approximately 300V) and a low-voltage state (approximately 150V). In the high-voltage state the target surface is metallic. This state is stable at very low O₂ flow rates. In the low-voltage state the target surface is oxidized. This state is stable at high O₂ flows, and is often referred to as the "poisoned" state because the target has become oxidized.

The poisoned state would appear to be the preferred state to perform the reactive deposition of the MgO film because it is easier to control, it deposits the MgO at a much lower rate than the high-voltage state, and the deposited MgO film is reliably well oxidized. However, as part of the development of the process of this invention it has been discovered that reactive deposition of MgO in the low-voltage or poisoned state is very aggressive to the underlying iron-containing metallic film on which the MgO is deposited. This results in a loss of magnetic moment at the interface of the CoFe ferromagnetic film and the MgO tunnel barrier. The MTJs fabricated in this state thus have undesirable high resistance (R) and low tunneling magnetoresistance (TMR).

The method of this invention reactively sputter deposits the MgO tunnel barrier in the high-voltage state. The reactive gas flow rate and sputter time are controlled to assure there is no substantial oxidation of the Mg target.

As an initial optional step in the inventive process, the target shutter 230 and substrate shutter 240 are both closed and pure Ar is introduced to the vacuum chamber 202. The target 210 is then activated and sputtered in the presence of pure Ar to eliminate any oxidized material from the target.

Next, with the target shutter 230 open and the substrate shutter 240 closed, the target 210 is again sputtered in pure Ar at sufficiently high power density, e.g., 3W/sqcm. This step conditions the chamber 202 by coating the chamber walls with the Mg metal. Because the chamber walls are metallic and an active oxygen-gettering surface, they provide additional O₂ pumping, thus delaying the onset of target oxidation. The coating of the walls with Mg removes any "memory" of prior oxygen processes in the chamber, which is important for a repeatable reactive deposition process. The substrate shutter 240 protects the CoFe metallic film on the substrate from exposure to the sputtered Mg atoms during this chamber conditioning step.

Next, with the target shutter 230 still open and the substrate shutter 240 still closed, the oxygen gas is introduced into the chamber at the desired flow rate. After the O₂ flow has stabilized, the substrate shutter 240 is opened while the desired power is applied to the Mg target 210 to begin the reactive deposition of the tunnel barrier. The power is applied for a time required to achieve the desired deposited thickness. It has been previously determined that sputter deposition occurs while there is minimal oxidation of the Mg target, at the desired O₂ flow rate.

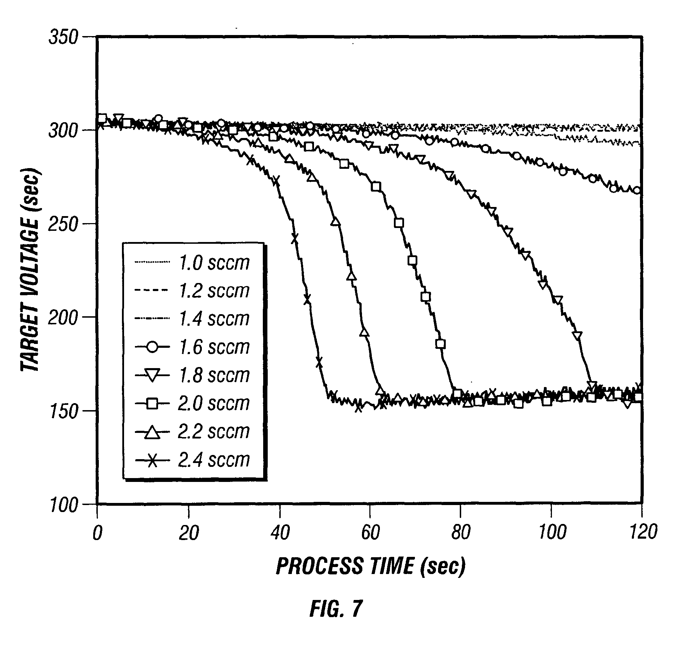

An important aspect of the process is that for each O₂ flow rate, the metallic mode of the Mg target has a finite lifetime. This is illustrated in Fig. 7, which shows a family of curves of target voltages with time. The objective is to sputter deposit at close to the initial target voltage, and terminate sputtering when the target voltage begins to decrease. A decrease in the target voltage indicates the beginning of oxidation of the target, which is undesirable. For example, for an O₂ flow rate of 1.8 sccm the Mg target stays substantially metallic for approximately 50 sec, after which significant oxidation occurs. During this 50 second time period, the target voltage has decreased to approximately 95% of its initial value. Thus the sputtering can also be terminated by monitoring the target voltage and terminating application of power to the target when the voltage reaches a predetermined value, e.g., 95% of its initial value. The total MgO thickness deposited in the initial high voltage period can, if sufficiently large, protect the CoFe electrode from the subsequent exposure to MgO deposition at falling target voltages, i.e., during target poisoning. However, it is best to avoid deposition as the target begins to be "poisoned" because the deposition rate is changing rapidly in the poisoning phase, making MgO thickness control difficult.

Thus the data of Fig. 7 allows a set of O₂ flow rates and associated time periods to be accumulated. Each member of the set will result in the deposition of a MgO tunnel barrier of a particular thickness. As a result, the desired O₂ flow rate and associated time period can be selected to deposit a MgO tunnel barrier of the desired thickness. Since it is desired to deposit while the Mg target is in metallic mode, i.e., no significant oxidation, the tunnel barrier must be completed while the target is still metallic. If a thicker tunnel barrier is required it can be deposited in several layers, with the process described above repeated for each layer.

While depositing in the metallic mode is very beneficial, the resulting MgO film must be well-oxidized. This requirement leads toward higher oxygen flow rates and thus toward a shorter metallic mode lifetime. This situation can be mitigated by the use of an optional final step of exposing the deposited MgO tunnel barrier to O₂ in the chamber. For example, an O₂ exposure of 100 mTorr for approximately 60 seconds is a "natural oxidation" step that encourages the tunnel barrier to achieve its natural MgO stoichiometry, and allows the use of lower O₂ flows during the reactive sputtering.

As an optional final step, after the sputtering has terminated, the deposited MgO tunnel barrier can be exposed to O₂ in the chamber at 100 mTorr for approximately 60 seconds. This optional "natural oxidation" step may encourage the tunnel barrier to achieve its natural MgO stoichiometry.

A second iron-containing film can then be sputter deposited directly on the MgO tunnel barrier to form the top ferromagnetic layer of the MTJ. If the MTJ is to be used in the MTJ read head described above the second iron-containing film can be a CoFe free ferromagnetic layer 110 (Fig. 4).

The MTJs made with the method of this invention have TMR and RA values significantly improved over previously reported MTJs with MgO tunnel barriers. Two typical MTJs made according to the method of this invention have a TMR of approximately 35% with a RA of approximately 3.5 Ω-(µm)² and a TMR of approximately 40% with a RA of approximately 5 Ω-(µm)².

While the method of this invention has been described for fabricating a MTJ read head, the method is fully applicable to fabricate other MTJ devices with a MgO tunnel barrier, including MTJ memory cells and MTTs.

While the present invention has been particularly shown and described with reference to the preferred embodiments, it will be understood by those skilled in the art that various changes in form and detail may be made without departing from the scope of the invention. Accordingly, the disclosed invention is to be considered merely as illustrative and limited in scope only as specified in the appended claims.

## Claims

1. A method for reactive sputter deposition of a magnesium oxide (MgO) film on an iron-containing film in a sputter deposition chamber comprising:
providing in the chamber a sputtering target consisting essentially of Mg and a substrate on which the iron-containing film is formed;
applying power to the target to sputter deposit Mg atoms onto the walls of the chamber while the iron-containing film is protected from exposure to the sputtered Mg atoms;
introducing O₂ gas into the chamber at a known flow rate;
exposing the iron-containing film to reactively
deposit MgO onto the iron-containing film; and
continuing the reactive deposition for a period of time, said time period and known flow rate selected to assure minimal oxidation of the target.

2. The method of claim 1 further comprising, prior to applying a voltage to the target to sputter deposit Mg atoms onto the walls of the chamber, applying power to the target in the presence of an inert gas, preferably Argon, to thereby substantially remove oxygen from the surface of the target.

3. The method of claim 1 further comprising, after reactive deposition for said time period, exposing the deposited MgO film to O₂ in the chamber.

4. The method of claim 1 wherein the iron-containing film is an alloy comprising cobalt (Co) and iron (Fe).

5. A method for fabricating a magnetic tunnel junction on a substrate in a sputter deposition chamber comprising:
depositing a first iron-containing film on the substrate;
covering the iron-containing film with a shutter;
applying power to a sputtering target consisting essentially of magnesium (Mg) to sputter deposit Mg atoms onto the walls of the chamber while the iron-containing film is protected by the shutter from exposure to the sputtered Mg atoms;
introducing O₂ gas into the chamber at a known flow rate;
removing the shutter from the iron-containing film to reactively deposit a MgO film onto the iron-containing film;
continuing the reactive deposition for a period of time, said time period and known flow rate selected to assure minimal oxidation of the target; and
depositing a second iron-containing film directly on the MgO film.

6. The method of claim 5 further comprising, prior to applying power to the target to sputter deposit Mg atoms onto the walls of the chamber, applying power to the target in the presence of an inert gas, preferably Argon, while the target is covered with a shutter to thereby substantially remove oxygen from the surface of the target.

7. The method of claim 5 further comprising, after reactive deposition for said time period and prior to deposition of the second iron-containing film, exposing the deposited MgO film to O₂ in the chamber.

8. The method of claim 1 or 5 further comprising, prior to applying power to the target to sputter deposit Mg atoms onto the walls of the chamber, etching the surface of the first iron-containing film.

9. The method of claim 1 or 5 wherein continuing the reactive deposition for a period of time comprises terminating application of power to the target when the target voltage reaches a predetermined value.

10. The method of claim 1 or 5 further comprising, prior to applying a power to the target to sputter deposit Mg atoms onto the walls of the chamber, determining a set of known O₂ gas flow rates and associated time periods.

11. The method of claim 1 or 5 wherein determining said set comprises applying power to the target and, for each known flow rate in the set, measuring the decrease in the target voltage with time.

12. The method of claim 1 or 5 wherein, as a result of the reactive deposition a MgO film has been deposited to a first thickness on the first iron-containing film, and further comprising repeating the method of claim 1 to thereby increase said thickness.

13. The method of claim 5 wherein the first iron-containing film and/or second iron-containing film comprise(s) an alloy comprising cobalt (Co) and iron (Fe).

14. The method of claim 5 wherein the magnetic tunnel junction is part of a magnetic tunnel junction read head, or part of a magnetic tunnel junction memory cell, or part of a magnetic tunnel transistor.

## Patentansprüche

1. Verfahren zur reaktiven Zerstaubungsablagerung eines Magnesiumoxid-(MgO)-Films auf einem Eisen-enthaltenden Film in einer Zerstaubungsablagerungskammer umfassend:
Bereitstellen eines Zerstaubungstargets in der Kammer, das im Wesentlichen aus Mg und einem Substrat besteht, auf dem der Eisen-enthaltende Film ausgebildet wird;
Anlegen einer Spannung an das Target, um Mg-Atome auf den Wänden der Kammer durch Zerstaubung abzulagern, während der Eisen-enthaltende Film gegen eine Beaufschlagung mit den zerstäubten Mg-Atomen geschützt ist;
Einführen eines O₂-Gases in die Kammer bei einer bekannten Flussrate;
Aussetzen des Eisen-enthaltenden Films einer reaktiven Ablagerung von MgO auf dem Eisen-enthaltenden Film; und
Fortsetzen der reaktiven Ablagerung während einer Zeitdauer, wobei die Zeitdauer und die bekannte Flussrate so ausgewählt werden, dass eine minimale Oxidation des Targets sichergestellt ist.

2. Verfahren nach Anspruch 1, ferner umfassend Anlegen einer Spannung an das Target in Anwesenheit eines inerten Gases, vorzugsweise Argon, vor dem Anlagen einer Spannung an das Target, um Mg-Atome auf den Wänden der Kammer durch Zerstaubung abzulagern, um dadurch im Wesentlichen den Sauerstoff von der Oberfläche des Targets zu entfernen.

3. Verfahren nach Anspruch 1, ferner umfassend Aussetzen des abgelagerten MgO-Films dem O₂ in der Kammer nach der reaktiven Ablagerung während der Zeitperiode.

4. Verfahren nach Anspruch 1, worin der Eisen-enthaltende Film eine Legierung ist, die Kobalt (Co) und Eisen (Fe) umfasst.

5. Verfahren zur Herstellung eines magnetischen Tunnelübergangs auf einem Substrat in einer Aufstaubungsablagerungskammer umfassend:
Abscheiden eines ersten Eisen-enthaltenden Films auf dem Substrat;
Abdecken des Eisen-enthaltenden Films mit einer Blende;
Anlegen einer Spannung an das Zerstaubungstarget, das im Wesentlichen aus Magnesium (Mg) besteht, um Magnesiumatome auf den Wänden der Kammer durch Zerstaubung abzulagern, während der Eisen-enthaltende Film durch die Blende gegen eine Beaufschlagung mit zerstaubten Mg-Atomen geschützt ist;
Einführen eines O₂-Gases in die Kammer mit einer bekannten Flussrate;
Entferne der Blende von dem Eisen-ethaltenden Film, um einen MgO-Film auf den Eisen-enthaltenden Film reaktiv abzulagern;
Fortsetzen der reaktiven Ablagerung während einer Zeitperiode, wobei die Zeitperiode und die bekannte Flussrate so ausgewählt werden, dass eine minimale Oxidation des Targets sichergestellt ist; und
Ablagerung eines zweiten Eisen-enthaltenden Films direkt auf dem MgO-Film.

6. Verfahren nach Anspruch 5 ferner umfassend Anlegen einer Spannung an das Target in Anwesenheit eines inerten Gases, vorzugsweise Argon, vor dem Anlegen der Spannung an das Target, um Mg-Atome auf den Wänden der Kammer durch Zerstaubung abzulagern, während das Target durch eine Blende abgedeckt ist, um dadurch im Wesentlichen den Sauerstoff von der Oberfläche des Targets zu entfernen.

7. Verfahren nach Anspruch 5 ferner umfassend Aussetzen des abgelagerten MgO-Films dem O₂ in der Kammer nach der reaktiven Ablagerung während der Zeitperiode und vor der Ablagerung des zweiten Eisen-Enthaltenden Films.

8. Verfahren nach Anspruch 1 oder 5 ferner umfassend Ätzen der Oberfläche des ersten Eisen-enthaltenden Films vor dem Anlegen einer Spannung an das Target, um die Mg-Atome auf den Wänden der Kammer durch Zerstaubung abzulagern.

9. Verfahren nach Anspruch 1 oder 5, worin das Fortsetzen der reaktiven Ablagerung während einer Zeitperiode die Beendigung des Anlegens einer Spannung an das Target umfasst, wenn die Targetspannung einen vorgegebenen Wert erreicht.

10. Verfahren nach Anspruch 1 oder 5 ferner umfassend Beendigen eines Satzes bekannter O₂-Gasströmungsraten und zugehöriger Zeitperioden vor dem Anlegen einer Spannung an das Target, um Mg-Atome auf den Wänden der Kammer durch Zerstaubung abzulagern.

11. Verfahren nach Anspruch 1 oder 5, worin die Bestimmung des Satzes das Anlegen einer Spannung an das Target und für jede bekannte Flussrate in dem Satz das Messen der Abnahme der Targetspannung mit der Zeit umfasst.

12. Verfahren nach Anspruch 1 oder 5, worin als Resultat der reaktiven Ablagerung ein MgO-Film bis zu einer ersten Dicke auf dem ersten Eisen-enthaltenden Film abgelagert wurde, und ferner umfassend das Wiederholen des Verfahrens von Anspruch 1, um dadurch die Dicke zu erhöhen.

13. Verfahren nach Anspruch 5, worin der erste Eisen-enthaltende Film und/oder der zweite Eisen-enthaltende Film eine Legierung aufweist bzw. aufweisen, die Kobalt (Co) und Eisen (Fe) umfasst.

14. Verfahren nach Anspruch 5, worin der magnetische Tunnelübergang Teil eines Schreibkopfes mit magnetischem Tunnelübergang oder Teil einer Speicherzelle mit magnetischem Tunnelübergang oder Teil eines magnetischen Tunneltransistors ist.

## Revendications

1. Méthode de déposition d'un film d'oxyde de magnésium (MgO) sur un film contenant du fer par pulvérisation cathodique réactive dans une chambre de déposition par pulvérisation cathodique comprenant:
- pourvoir dans la chambre une cible de pulvérisation cathodique consistant essentiellement en Mg et un substrat sur lequel le film contenant du fer est formé;
- appliquer la puissance à la cible pour déposer par pulvérisation cathodique les atomes de Mg sur les parois de la chambre pendant que le film contenant du fer est protégé de l'exposition aux atomes de Mg pulvérisés;
- introduire le gaz O₂ dans la chambre à un débit connu;
- exposer le film contenant du fer pour déposer de manière réactive le MgO sur le film contenant du fer; et
- continuer la déposition réactive pour une période de temps, ladite période de temps et le débit connu choisis pour assurer l'oxydation minimale de la cible.

2. Méthode selon la revendication 1 comprenant de plus, avant d'appliquer une tension à la cible pour déposer par pulvérisation cathodique les atomes de Mg sur les parois de la chambre, appliquer la puissance à la cible dans la présence d'un gaz inerte, préférablement de l'argon, pour éloigner substantiellement de cette manière l'oxygène de la surface de la cible.

3. Méthode selon la revendication 1 comprenant de plus, après la déposition réactive pour ladite période de temps, exposer le film déposé de MgO à de l'O₂ dans la chambre.

4. Méthode selon la revendication 1 où le film contenant du fer est un alliage comprenant du cobalt (Co) et du fer (Fe).

5. Méthode de fabrication d'une jonction de tunnel magnétique sur un substrat dans une chambre de déposition par pulvérisation cathodique comprenant:
- déposer un premier film contenant du fer sur le substrat;
- couvrir le film contenant du fer avec un écran;
- appliquer la puissance à une cible de pulvérisation consistant essentiellement en magnésium (Mg) pour déposer par pulvérisation les atomes de Mg sur les parois de la chambre pendant que le film contenant du fer est protégé par l'écran de l'exposition aux atomes de Mg pulvérisés;
- introduire le gaz 02 dans la chambre à un débit connu;
- éloigner l'écran du film contenant du fer pour déposer de manière réactive un film de MgO sur le film contenant du fer; et
continuer la déposition réactive pour une période de temps, ladite période de temps et le débit connu choisis pour assurer l'oxydation minimale de la cible; et
- déposer un second film contenant du fer directement sur le film de MgO.

6. Méthode selon la revendication 5 comprenant de plus, avant d'appliquer la puissance à la cible pour déposer par pulvérisation cathodique les atomes de Mg sur les parois de la chambre, appliquer la puissance à la cible dans la présence d'un gaz inerte, préférablement de l'argon, pendant que la cible est couverte avec un écran pour éloigner substantiellement de cette manière l'oxygène de la surface de la cible.

7. Méthode selon la revendication 5 comprenant de plus, après la déposition réactive pour ladite période de temps et avant la déposition du second film contenant du fer, exposer le film déposé de MgO à de l'O₂ dans la chambre.

8. Méthode selon la revendication 1 ou 5 comprenant de plus, avant d'appliquer la puissance à la cible pour déposer les atomes de Mg par pulvérisation cathodique sur les parois de la chambre, graver la surface du premier film contenant du fer.

9. Méthode selon la revendication 1 ou 5 où la continuation de la déposition réactive pour une période de temps comprend la terminaison d'application de puissance à la cible quand la tension de la cible atteint une valeur prédéterminée.

10. Méthode selon la revendication 1 ou 5 comprenant de plus, avant d'appliquer la puissance à la cible pour déposer les atomes de Mg par pulvérisation cathodique sur les parois de la chambre, déterminer un jeu de débits de gaz 02 connus et les périodes de temps associées.

11. Méthode selon la revendication 1 ou 5 où déterminer ledit jeu comprend d'appliquer la tension à la cible et, pour chaque débit connu dans le jeu, mesurer la décroissance dans la tension de la cible avec le temps.

12. Méthode selon la revendication 1 ou 5 où, comme un résultat de la déposition réactive d'un film de MgO a été déposé à une première épaisseur sur le premier film contenant du fer, et comprenant de plus la répétition de la méthode selon la revendication 1 pour croître de cette manière ladite épaisseur.

13. Méthode selon la revendication 5 où, le premier film contenant du fer et/ou le second film contenant du fer comprennent (nd) un alliage comprenant du cobalt (Co) et du fer (Fe).

14. Méthode selon la revendication 5 où, la jonction de tunnel magnétique est part d'une tête de lecture de jonction de tunnel magnétique, ou part d'une cellule de mémoire de jonction de tunnel magnétique, ou part d'un transistor de tunnel magnétique.
